# FASCICULE DE BREVET EUROPEEN

(11) **EP 0 395 544 B1**
(45) Date de publication et mention de la délivrance du brevet: **27.03.1996**
(21) Numéro de dépôt: 90420202.5
(22) Date de dépôt: 23.04.1990
(51) Int. Cl.: H05K 1/05, H01L 23/14, C25D 11/12

(54) **Substrats métalliques isolés et procédé de fabrication desdits substrats**
Isolierte metallische Substrate und Verfahren zur Herstellung dieser Substrate
Insulated metallic substrates and method of making these substrates

(30) Priorité: 24.04.1989 FR 8906136
(43) Date de publication de la demande: 31.10.1990
(73) Titulaire: Société Anonyme de Traitement des Métaux et Alliages SATMA, 38570 Goncelin (FR)
(72) Inventeur: Rabiet, Jacques, F-38570 Goncelin (FR); Gimenez, Philippe, F-38130 Echirolles (FR); Guillou, Rémi, F-44000 Nantes (FR); Drapier, Claude, F-92420 Vaucresson (FR)
(74) Mandataire: Mougeot, Jean-Claude

(56) Documents cités:
- CH-A- 455 008
- DE-A- 3 626 232
- GB-A- 2 206 451
- US-A- 2 578 400
- US-A- 3 385 732

## Description

### DOMAINE TECHNIQUE DE L'INVENTION

La présente invention est relative à des substrats métalliques isolés et à leur procédé de fabrication. Elle s'applique particulièrement à la réalisation de circuits imprimés d'interconnexion de composants électroniques de puissance utilisés, par exemple, dans l'industrie automobile. De tels circuits peuvent se présenter en conformation plane ou spatiale et comporter un ou plusieurs niveaux conducteurs "simple face", "double face à trous métallisés" ou "multicouche".

### ETAT DE LA TECHNIQUE ANTERIEURE

Depuis de nombreuses années, les circuits imprimés d'interconnexion de composants électroniques sont obtenus par gravure de substrats constitués par exemple d'une feuille mince de cuivre collée sur un support isolant.

Parmi les matériaux couramment utilisés comme support pour les substrats rigides, on peut citer par exemple :
- le papier imprégné de résine phénolique qui a été particulièrement développé au Japon dans le secteur grand public
- le tissu de verre imprégné de résine époxy, plutôt réservé au secteur professionnel en raison de ses meilleures performances électriques.

Pour les substrats flexibles, ce sont des films polymères qui servent de support :
- soit en polyimide lorsqu'il faut une bonne tenue à chaud,
- soit en polyester si le prix est un critère important.

Tous ces supports électriquement isolants ont de mauvaises conductivités thermiques et ne peuvent donc pas participer à la dissipation de la chaleur dégagée par les composants de puissance. Pour éviter la destruction de ces derniers par élévation de leur température, diverses solutions sont envisagées mais, jusqu'à présent, aucune ne donne entièrement satisfaction.

Il est aussi connu de positionner les composants de puissance sur des supports séparés de type échangeur, réalisés par exemple par découpe de profilés à ailettes en aluminium, mais alors la fonction interconnexion de ces composants ne peut plus être intégrée sur le circuit imprimé.

Il est également connu d'utiliser des supports en céramique, par exemple en alumine, cordiérite ou nitrure d'aluminium, qui ont une bonne conductivité thermique, en mettant en oeuvre par exemple les techniques dites à couche épaisse ou les multicouches. Malheureusement, ces matériaux ont l'inconvénient d'être chers, fragiles et de n'être disponibles qu'en plaques de petites dimensions excédant rarement le dm.

Plus récemment, la technologie du montage en surface des composants sur le circuit imprimé, autorisant un meilleur transfert thermique entre composants et substrat a conduit au concept de substrat métallique isolé, appelé SMI et qui est un matériau constitué :
- d'une embase métallique, par exemple en aluminium, jouant le rôle de drain thermique
- d'un film mince conducteur de l'électricité, telle qu'une feuille de cuivre par exemple, qui peut être gravé chimiquement pour réaliser les circuits d'interconnexion,
- et d'un isolant interposé entre les deux métaux.

Le mode d'utilisation d'un tel substrat est par exemple décrit dans le brevet français n° 2560437 qui revendique "un procédé de fabrication de circuits électroniques de puissance miniaturisés".

Le problème qui se pose dans les SMI est d'obtenir à la fois un bon isolement électrique entre l'embase et la feuille et une bonne dissipation thermique par l'embase.

Or, l'amélioration de la première de ces grandeurs peut se faire par l'augmentation de l'épaisseur de l'isolant mais cela va à l'encontre de la deuxième.

Il est donc apparu à la demanderesse qu'il était difficile de concilier ces exigences contradictoires pour atteindre les niveaux de performance généralement imposés par les utilisateurs.

Ainsi, pour les applications automobiles par exemple, il est demandé de garantir, sous une tension continue appliquée de 500 V, des résistances d'isolement supérieures à 10⁵ MΩ entre conducteurs et embase ou entre pistes conductrices. Outre cette caractéristique et la nécessité de dissiper la chaleur dégagée par les composants, il faut assurer une bonne adhérence des conducteurs de cuivre, l'ensemble de ces propriétés devant être conservé après divers tests d'environnement tels que vieillissement, chocs thermiques, exposition à la chaleur humide ou immersion dans divers solvants (par exemple hydrocarbures).

L'une des solutions proposées jusqu'à présent consiste à utiliser un substrat métallique isolé ayant pour isolant un film de polyimide de 25 µm qui doit être enduit sur ses deux faces d'un adhésif, ce qui conduit à une épaisseur totale isolante de l'ordre de 75 µm; une telle épaisseur constitue un écran notable aux transferts thermiques entre les composants et l'embase en aluminium.

Une autre solution décrite dans le brevet allemand DE-A-3626232 est basée sur le traitement suivant :
- "on oxyde la surface entière d'une embase en aluminium pour former un oxyde jouant le rôle d'isolant électrique
- on applique un adhésif thermodurcissable sur le substrat oxydé,
- on place une feuille de cuivre sur le film adhésif,
- on chauffe le composite pour durcir le film adhésif, ladite oxydation étant réalisée électrolytiquement, c'est-à-dire par anodisation".

Mais, dans ce brevet, aucune indication n'est donnée sur les caractéristiques d'isolement électrique obtenues entre l'embase en aluminium et les conducteurs en cuivre, ou de dissipation thermique par l'embase.

C'est pour améliorer cette situation que la demanderesse a recherché une solution utilisant une couche d'oxyde anodique qui présente a priori les avantages suivants :
- bonne conductivité thermique
- isolement électrique élevé
- adhérence directe sur l'aluminium
- possibilité de disposer d'une rugosité externe favorable à l'adhérence du film mince conducteur.

A ce sujet, il est décrit dans le brevet GB 2206451 un panneau d'aluminium pour support électronique, recouvert d'un film anodique comprenant une couche barrière sur laquelle croît une couche poreuse; la couche barrière est très fine et on peut faire varier son épaisseur en agissant sur le procédé d'anodisation ou en utilisant des solutions d'acide borique/borate.

Il est également décrit dans le brevet US 2578400 un procédé dans lequel une surface d'aluminium subit d'abord un traitement conventionnel d'anodisation en présence en particulier d'acide sulfurique ou oxalique, suivi d'un traitement d'anodisation, en présence en particulier de trioxide de chrome voire de borate d'ammonium, borax, etc..., pour donner une fine couche imperméable directement en contact avec l'aluminium.

### OBJET DE L'INVENTION

Il est connu de l'homme de l'art que l'oxydation anodique de l'aluminium peut conduire, suivant les conditions d'anodisation, et notamment suivant la nature de l'électrolyte mis en oeuvre, soit à une alumine compacte, soit à une alumine poreuse.

Dans le premier cas, la couche dite "barrière" a une épaisseur qui ne dépend que de la tension appliquée pour sa formation (1,4 nm/V), la tension de service devant nécessairement être inférieure à cette dernière; ainsi, pour une utilisation sous 500 V, il est généralement recommandé d'oxyder sous une tension supérieure, par exemple à 600 V et l'on obtient dans ce cas une couche d'épaisseur 850 nm (0,85 µm).

Dans le deuxième cas, la couche, qui peut atteindre plusieurs dizaines de microns, a une structure poreuse contenant un grand nombre de trous cylindriques de très faible diamètre dont les axes sont perpendiculaires à la surface de l'aluminium et qui traversent la plus grande partie de la couche en laissant en fond de pores une couche barrière compacte de quelques dizaines de nm.

Or, il a été constaté qu'aucune de ces couches considérées séparément ne répond à l'ensemble des spécifications : les couches compactes qui peuvent avoir des résistances d'isolement satisfaisantes sont inaptes à un bon accrochage des adhésifs, et inversement les couches poreuses qui donnent une bonne adhérence ont des propriétés d'isolement électrique très insuffisantes.

Il était donc intéressant de chercher à combiner les avantages de ces deux types de couches et de rechercher les conditions de traitement par double anodisation de l'aluminium en vue de procurer à la fois les qualités d'isolement électrique, de conductivité thermique et l'aptitude à une bonne adhérence avec des films métalliques.

### DESCRIPTION DE L'INVENTION

L'invention consiste donc en un substrat métallique isolé comportant une embase d'aluminium, un isolant constitué d'une pellicule d'alumine obtenue par anodisation de ladite embase sur au moins une de ses faces et au moins un film métallique destiné a être transformé par gravure chimique en un réseau de conducteurs caractérisés en ce que ladite pellicule d'alumine est formée d'une zone compacte, uniforme, adhérente à l'aluminium ayant une épaisseur supérieure à 500 nm et d'une couche poreuse à surface externe rugueuse.

Ainsi, le substrat de l'invention a pour particularité d'avoir une zone compacte d'épaisseur supérieure à celle habituellement rencontrée avec ce type de couche et qui dépasse rarement 100 nm, ladite zone étant recouverte d'une couche poreuse présentant une très forte rugosité externe favorable à son accrochage avec un film métallique qui peut être une feuille par exemple.

De préférence, la zone compacte au contact de l'aluminium a une épaisseur comprise entre 500 et 1200 nm mais les meilleurs résultats sont obtenus dans la fourchette d'épaisseur comprise entre 500 et 1000 nm. Si l'épaisseur est inférieure à 500 nm, on constate un isolement électrique insuffisant, par contre, avec des épaisseurs supérieures à 1200 nm, la conductivité thermique devient trop faible.
Quant à la couche poreuse, elle a de préférence une épaisseur comprise entre 5000 et 50 000 nm (5 à 50 µm), fourchette qui peut être réduite aux valeurs de 15000 à 30000 nm (15 à 30 µm) pour affiner les résultats. Si l'épaisseur de cette couche est inférieure à 5 µm, l'accrochage du film métallique devient insuffisant, au contraire au-delà de 50 µm, elle n'apporte qu'une amélioration réduite de l'adhérence.

Les photos jointes à la demande illustrent ces deux aspects particuliers .

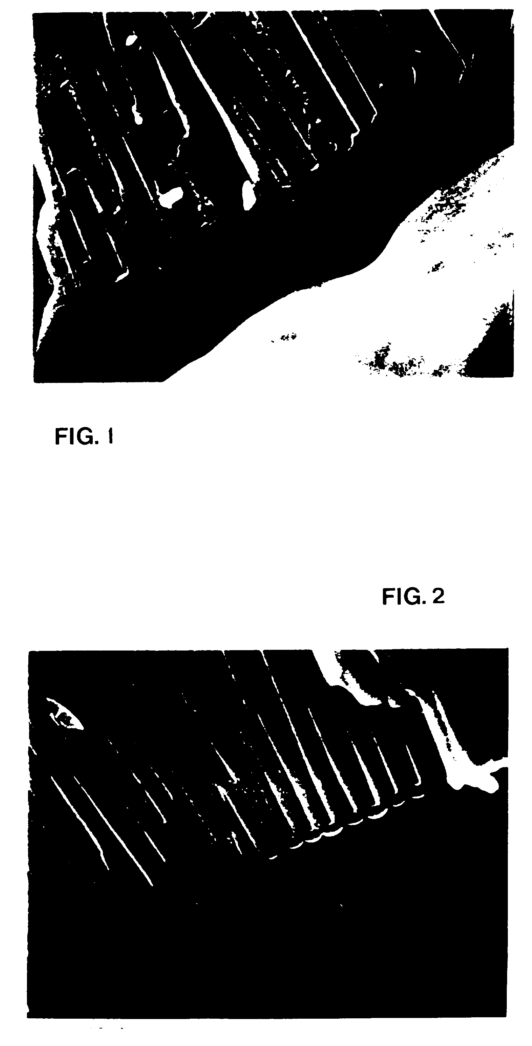

Sur la photo 1 réalisée à un grandissement de 25000, on voit la zone compacte uniforme et adhérente au contact de l'aluminium recouverte d'une couche poreuse. Elle est à comparer avec la photo 2 réalisée au même grossissement mais avec une embase revêtue d'une pellicule d'oxyde suivant l'art antérieur où on constate que la zone compacte située à la base des pores a une épaisseur plus de 10 fois inférieure à celle de la zone selon l'invention.

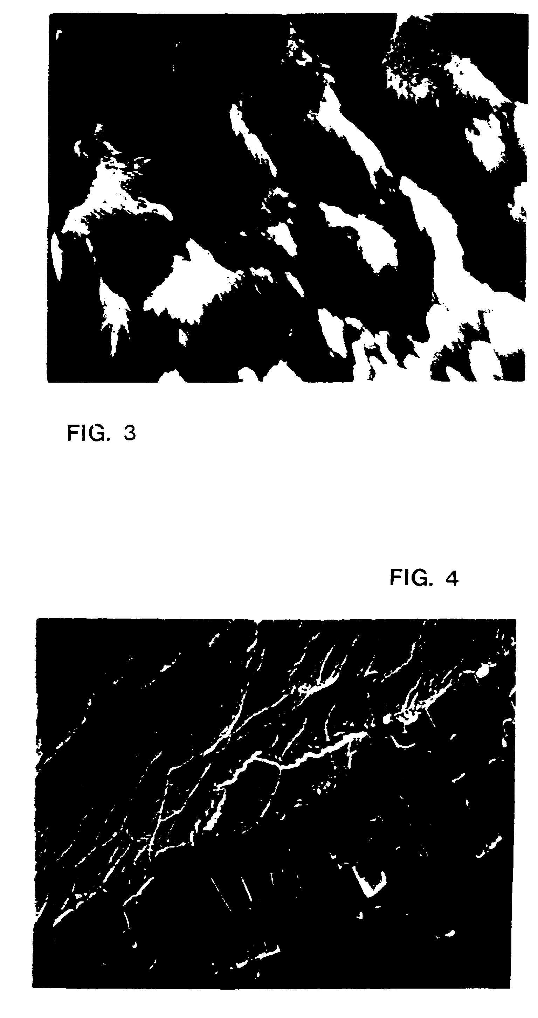

Sur la photo 3 réalisée à un grandissement de 3200, on voit la forte rugosité présentée par la surface externe de la couche poreuse. Cette surface est à comparer à celle de la photo 4 réalisée avec un grandissement de 25000 sur une embase d'aluminium recouverte uniquement d'une couche poreuse où on peut voir une surface externe craquelée mais très plane.

Cette différence permet de montrer que l'invention n'est pas une simple juxtaposition d'une couche poreuse et d'une couche compacte de l'art antérieur mais qu'il s'agit d'un revêtement tout à fait particulier : une pellicule poreuse à forte couche barrière et à surface externe d'un profil nouveau.

Les pellicules d'alumine anodique ayant une telle structure présentent, outre leur bonne conductivité thermique, les principales caractéristiques suivantes :
- l'oxyde est parfaitement adhérent à l'aluminium,
- la résistance d'isolement sous 500 V est supérieure à 10⁵ MΩ,
- la quantité d'oxyde donnant cette résistance d'isolement peut être limitée à une épaisseur de 10 à 25 µm,
- la rugosité de la surface extérieure est très favorable à l'accrochage d'un film métallique capable de constituer un réseau conducteur.

Ces pellicules se prêtent donc particulièrement bien à la réalisation de substrats métalliques isolés, car on peut appliquer à leur surface un film conducteur, par exemple à l'aide de l'une quelconque des méthodes suivantes séparément ou en combinaison :
- contre-collage d'une feuille électrodéposée en cuivre d'épaisseur 35 µm par exemple, l'adhésif pouvant être indifféremment déposé au préalable sur l'alumine ou sur le cuivre. Cet adhésif qui est choisi de préférence dans le groupe formé par les résines acrylique et époxy permet également d'adapter les différences de coefficient de dilatation entre ces conducteurs et l'alumine et par conséquent de supporter les déplacements relatifs que subissent les conducteurs au cours des cycles thermiques des circuits gravés;
- cuivrage chimique de l'alumine après activation par sels métalliques et rechargement électrolytique par l'une des deux méthodes suivantes : méthode soustractive dite "panel plating" ou méthode semi-additive dite "pattern plating", afin de disposer d'une épaisseur suffisante de cuivre; dans ce cas, il faudra veiller à ce que la structure du métal conducteur corresponde à une capacité de déformation suffisante pour supporter les déplacements relatifs engendrés par les cycles thermiques;
- évaporation sous vide de cuivre en couche mince ou toute autre méthode de dépôt physique, suivie là aussi d'un rechargement électrolytique selon l'une des deux méthodes ci-dessus,
- sérigraphie d'encres polymères conductrices, par exemple à base de cuivre.

La plupart des alliages d'aluminium peuvent être utilisés comme embase pour obtenir ces couches particulières; toutefois, les alliages de la série 1000 selon les normes de l'Aluminium Association sont préférés, car ils donnent des qualités d'oxyde répondant mieux aux exigences requises.

Ces embases peuvent présenter à la fois une conformation plane éventuellement percée de trous dont le diamètre et la position sont conformes à l'usage final ou une conformation spatiale éventuellement percée de trous dont la morphologie est en relation avec l'usage final.

De préférence, le film métallique est en cuivre, mais peut également appartenir au groupe constitué par le constantan et les alliages nickel-chrome quand les substrats sont destinés à la fabrication de réseaux résistifs.

L'invention concerne également un procédé d'obtention desdits substrats.

Ce procédé est caractérisé en ce que l'embase en aluminium est soumise sur l'une au moins de ses faces à un traitement dans un bain d'anodisation poreuse puis dans un bain d'anodisation barrière.
Ainsi, le procédé comporte une bi-anodisation et qui débute par une anodisation poreuse, la zone compacte se développant par la suite sous la couche poreuse.
Initialement, l'embase en aluminium est dégraissée puis décapée par exemple dans des solutions aqueuses d'acide sulfochromique et rincées soigneusement. Puis elle est soumise à une anodisation du type poreux qui est obtenue à l'aide d'un électrolyte appartenant au groupe constitué par l'acide sulfurique, l'acide sulfosalicylique, l'acide chromique, l'acide phosphorique et toute combinaison d'au moins deux desdits acides.

De préférence, on choisit l'acide sulfosalicylique généralement utilisé dans l'oxydation autocolorée de l'aluminium et qui donne des pores ayant un bon pouvoir d'accrochage.
Enfin, l'embase ainsi revêtue de sa pellicule poreuse est soumise à une nouvelle anodisation au cours de laquelle on développe la zone compacte en utilisant un bain d'électrolyte appartenant au groupe de sels en solution aqueuse constitué par le tartrate d'ammonium, le borate d'ammonium, le chromate de potassium, le citrate d'ammonium, et toute combinaison d'au moins deux desdits sels.
Un colmatage par immersion de 5 à 10 min dans l'eau bouillante peut être effectué sur ces couches bi-anodisées.

Quant au placage du film conducteur sur l'alumine anodique, il peut être réalisé, dans le cas du contre-collage, à l'aide de divers adhésifs qu'il est toutefois préférable de choisir parmi l'une des deux familles de résines acryliques ou résines époxy qui conviennent généralement bien aux feuilles de cuivre. Si la couche conductrice est plutôt réalisée à partir d'une méthode physique de dépôt en couche mince, il est généralement recommandé de déposer une première couche d'épaisseur voisine de 1 µm avant de faire le rechargement électrolytique, qui pourra atteindre par exemple une épaisseur de 35 µm.

L'invention n'est pas limitée à la fabrication de substrats pour circuits d'interconnexion simple face, mais se prête également à la réalisation de substrats pour circuits dits "double face à trous métallisés". Dans ce cas, les principales séquences de fabrication sont par exemple les suivantes :
- perçage de trous dans la plaque d'aluminium,
- bi-anodisation de la plaque aluminium sur les deux faces et à l'intérieur des trous,
- cuivrage de la totalité de la surface extérieure de l'alumine, soit par méthode chimique avec activation par sels métalliques, soit par méthode physique,
- rechargement électrolytique par l'une des deux méthodes panel plating ou pattern plating.

Une autre variante du procédé, moins performante du point de vue de la dissipation thermique, consiste à contrecoller sur l'aluminium convenablement anodisé un circuit double face à trous métallisés de conception traditionnelle (avec isolant en verre epoxy entre les deux feuilles de cuivre) et préalablement gravé. La généralisation de ce même principe conduit à un substrat métallique isolé à circuits conducteurs multicouches.

L'invention se prête également à la réalisation de substrats métalliques isolés à conformation spatiale, cette mise en forme par pliage, emboutissage ou même usinage pouvant être appliquée initialement à la tôle d'aluminium, et donner lieu ensuite aux mêmes séquences de fabrication que ci-dessus, c'est-à-dire bi-anodisation et cuivrage.

L'invention peut également être mise en oeuvre pour la fabrication de réseaux résistifs obtenus par gravure chimique d'une feuille mince métallique en constantan ou en alliage nickel-chrome.

L'invention peut être illustrée à l'aide des exemples d'application suivants :

### Exemple 1

Des feuilles en alliage d'aluminium des types 1050 et 1199 ont été dégraissées au moyen d'une solution alcaline de nom commercial DIVERSEY D 708 à raison de 15 g/l et à une température de 65°C, puis rincées avant d'être décapées par une solution d'acide sulfochromique contenant environ 150 g/l de H₂SO₄ et 50 g/l de CrO₃ et rincées soigneusement. Lesdites feuilles ont alors été soumises à une anodisation du type autocoloration dans un bain contenant 100 g/l d'acide sulfosalicylique à 20°C en faisant passer un courant électrique continu de 2A/dm/face pendant 40 min environ, de façon à développer une couche d'oxyde poreux de 25 µm d'épaisseur en moyenne. Puis, après rinçage à l'eau, les feuilles ont subi une deuxième anodisation dans une solution d'acide borique H₃Bo₃ à 70 g/l et d'ammoniaque de manière à obtenir une résistance chimique voisine de 3500Ω . La tension moyenne du courant électrique continu était de 200 volts et la quantité de courant consommée de 180 cb/dm. La couche d'oxyde compact obtenue était en moyenne de 1 µm.

Après rinçage et séchage, les substrats ainsi réalisés ont été soumis à des mesures de résistance d'isolement sous 500 volts et des temps d'application d'une minute. Puis l'isolant des substrats a été préplaqué avec des feuilles d'adhésif acrylique d'épaisseur 25 µm et recouverts d'une couche de cuivre électrodéposée d'épaisseur 35 µm. L'ensemble a été pressé pendant 1 heure à 180°C sous 6,7 MPa et soumis à des essais de détermination de la force de pelage. Les résultats des essais figurent dans le tableau suivant où on trouve également les résultats de mesures de résistance d'isolement effectués sur des substrats ayant subi une seule anodisation en milieu sulfosalicylique dans les conditions décrites ci-dessus ainsi que des mesures de force de pelage effectuées après association avec le film métallique réalisée dans les mêmes conditions que ci-dessus.

**TABLEAU**

| | | Bi-anodisation (suivant l'invention) | | | | Mono-anodisation | |
|---|---|---|---|---|---|---|---|
| Type d'aluminium | | 1050 | | 1199 | | 1050 | 1199 |
| N° Echantillon | | 1 | 2 | 3 | 4 | 1 | 3 |
| Résistance d'isolement en 10⁵MΩ | R moyen | 4,46 | 5,61 | 13,8 | 14,7 | 0,08 | 0,17 |
| | R mini | 2,0 | 3,5 | 7 | 11,5 | 0,02 | 0,14 |
| | R maxi | 6,5 | 7,0 | >15,0 | >15,0 | 0,15 | 0,20 |
| Force de pelage en N/mm | | 3 | 3,08 | 2,9 | 2,95 | 2,75 | 2,75 |

Ce tableau montre que la bianodisation tout en améliorant les qualités d'adhérence multiplie au moins par un facteur 50 les résistances d'isolement.

### Exemple 2

Des feuilles d'aluminium de type 1050 ont été bianodisées dans les conditions de l'exemple 1 sauf en ce qui concerne la première anodisation qui a été faite dans un bain contenant 180 g/l d'acide sulfurique à 18°C en faisant passer un courant électrique continu de 1,5 A/dm/face pendant 60 minutes de façon à développer une couche d'oxyde poreux d'épaisseur 25 µm en moyenne.

On a mesuré sur les substrats ainsi obtenus les résistances d'isolement suivantes :

| | | |
|---|---|---|
| Résistance d'isolement en 10⁵MΩ | R moyen | 1,62 |
| | R mini | 1,1 |
| | R maxi | 2,7 |
| Force de pelage en N/mm | | 2,7 |

On constate que les valeurs de résistance sont un peu moins bonnes qu'avec l'acide sulfosalicylique mais en tout cas supérieures à celles obtenues par monoanodisation.

## Revendications

1. Substrats métalliques isolés comportant une embase d'aluminium, un isolant constitué d'une pellicule d'alumine obtenue par anodisation de ladite embase sur au moins une de ses faces et au moins un film métallique destiné à être transformé par gravure chimique en un réseau conducteurs, ladite pellicule d'alumine comportant une zone compacte uniforme adhérente à l'aluminium et une couche poreuse à surface externe rugueuse , caractérisée en ce que la zone compacte a une épaisseur supérieure à 500 nm.

2. Substrats selon la revendication 1 caractérisés en ce que la zone compacte a une épaisseur comprise entre 500 et 1000 nm.

3. Substrats selon la revendication 1 caractérisés en ce que la couche poreuse a une épaisseur comprise entre 5 et 50 µm.

4. Substrats selon la revendication 3 caractérisés en ce que la couche poreuse a une épaisseur comprise entre 15 et 30 µm.

5. Substrats selon la revendication 1 caractérisés en ce que le film est séparé de la couche d'alumine poreuse par l'intermédiaire d'un adhésif.

6. Substrats selon la revendication 5 caractérisés en ce que l'adhésif est capable de supporter les déplacements relatifs des conducteurs engendrés par les cycles thermiques que subissent les circuits gravés.

7. Substrats selon la revendication 5 caractérisé en ce que l'adhésif est choisi dans le groupe des résines acryliques et epoxy.

8. Substrats selon la revendication 1 caractérisés en ce que l'aluminium est choisi parmi la série 1000 suivant les normes de l'Aluminium Association.

9. Substrats selon la revendication 1 caractérisés en ce que l'embase en aluminium présente une conformation plane.

10. Substrats selon la revendication 9 caractérisés en ce que l'embase en aluminium est percée de trous dont le diamètre et la position sont conformes à l'usage final.

11. Substrats selon la revendication 1 caractérisé en ce que l'embase en aluminium présente une conformation spatiale.

12. Substrats selon la revendication 11 caractérisés en ce que l'embase en aluminium est percée de trous dont la morphologie est en relation avec l'usage final.

13. Substrats selon la revendication 1 caractérisés en ce que le film métallique est en cuivre.

14. Substrats selon la revendication 1 caractérisé en ce que le film métallique appartient au groupe constiuté par le constantan, les alliages nickel chrome.

15. Procédé de fabrication des substrats de la revendication 1 comportant le traitement d'une embase en aluminium, sur l'une au moins de ses faces, à l'aide d'un bain d'anodisation poreuse puis d'un bain d'anodisation barrière, caractérisé en ce que le bain d'anodisation poreuse est à base d'acide sulfosalicylique et le bain d'anodisation barrière à base d'une solution aqueuse de l'un au moins des sels suivants : tartrate d'ammonium, borate d'ammonium, chromate de potassium, citrate d'ammonium.

16. Procédé selon la revendication 15 caractérisé en ce que le bain d'anodisation est formé de borate d'ammonium.

17. Procédé selon la revendication 15 caractérisé en ce que le film métallique est obtenu par dépôt physique sous vide suivi d'un rechargement électrolytique.

## Patentansprüche

1. Isolierte metallische Substrate mit einer Aluminiumunterlage, einem aus einem Aluminiumoxidüberzug gebildetem Isolierstoff, der durch Anodisierung der Unterlage auf wenigstens einer ihrer Oberflächen erhalten wurde, und wenigstens einem Metallfilm, der zur Umwandlung in ein Leiternetz durch chemisches Ätzen bestimmt ist, wobei der Aluminiumoxidüberzug eine kompakte, gleichmäßige, am Aluminium haftende Zone und einer porösen Schicht mit rauher äußerer Oberfläche aufweist,
dadurch gekennzeichnet,
daß die kompakte Zone eine Dicke über 500 nm hat.

2. Substrate nach dem Anspruch 1, dadurch gekennzeichnet, daß die kompakte Zone eine Dicke zwischen 500 und 1000 nm hat.

3. Substrate nach dem Anspruch 1, dadurch gekennzeichnet, daß die poröse Schicht eine Dicke im Bereich von 5 bis 50 µm hat.

4. Substrate nach dem Anspruch 3, dadurch gekennzeichnet, daß die poröse Schicht eine Dicke zwischen 15 und 50 µm hat.

5. Substrate nach dem Anspruch 1, dadurch gekennzeichnet, daß der Film von der porösen Aluminiumoxidschicht mittels eines Klebers getrennt ist.

6. Substrate nach dem Anspruch 5, dadurch gekennzeichnet, daß der kleber dazu geeignet ist, die Relativverschiebungen der Leiter auszuhalten, die durch die Wärmezyklen erzeugt werden, die die geätzten Schaltungen durchmachen.

7. Substrate nach dem Anspruch 5, dadurch gekennzeichnet, daß der Kleber aus der Gruppe der Acryl- und Epoxyharze gewählt wird.

8. Substrate nach dem Anspruch 1, dadurch gekennzeichnet, daß das Aluminium aus der Serie 1000 nach den Normen der Aluminium Association gewählt wird.

9. Substrate nach dem Anspruch 1, dadurch gekennzeichnet, daß die Aluminiumunterlage eine ebene Gestaltung aufweist.

10. Substrate nach dem Anspruch 9, dadurch gekennzeichnet, daß die Aluminiumunterlage von Löchern durchbohrt ist, deren Durchmesser und Lage der Endverwendung entsprechend sind.

11. Substrate nach dem Anspruch 1, dadurch gekennzeichnet, daß die Aluminiumunterlage eine räumliche Gestaltung aufweist.

12. Substrate nach dem Anspruch 11, dadurch gekennzeichnet, daß die Aluminiumunterlage von Löchern durchbohrt ist, deren Morphologie in Beziehung mit der Endverwendung ist.

13. Substrate nach dem Anspruch 1, dadurch gekennzeichnet, daß der Metallfilm aus Kupfer ist.

14. Substrate nach dem Anspruch 1, dadurch gekennzeichnet, daß der Metallfilm zu der aus dem Konstantan und den Nickel-Chrom-Legierungen gebildeten Gruppe gehört.

15. Verfahren zur Herstellung der Substrate des Anspruchs 1, das die Behandlung einer Aluminiumunterlage auf wenigstens einer ihrer Oberflächen mittels eines Bades zur porösen Anodisierung und danach eines Bades zur Sperreanodisierung aufweist, dadurch gekennzeichnet, daß das Bad zur porösen Anodisierung auf Sulfosalicylsäurebasis ist und das Bad zur Sperreanodisierung auf Basis einer wäßrigen Lösung wenigstens eines der folgenden Salze ist: Ammoniumtartrat, Ammoniumborat, Kaliumchromat und Ammoniumcitrat.

16. Verfahren nach dem Anspruch 15, dadurch gekennzeichnet, daß das Anodisierungsbad aus Ammoniumborat gebildet wird.

17. Verfahren nach dem Anspruch 15, dadurch gekennzeichnet, daß der Metallfilm durch physikalische Abscheidung im Vakuum mit nachfolgender elektrolytischer Verdickung erhalten wird.

## Claims

1. Insulated metal substrate comprising an aluminum base, an insulant constituted by an alumina film by anodising said base on at least one of its faces and at least one metal film for transformation by chemical etching into a conductive network, said alumina film having a uniform compact zone, adherent to aluminium, and a porous layer with a rough external surface, characterised in that the compact zone has a thickness greater than 500 nm.

2. Substrates according to claim 1, characterised in that the compact zone has a thickness of between 500 and 1,000 nm.

3. Substrates according to claim 1, characterised in that the porous layer has a thickness of between 5 and 50 µm.

4. Substrates according to claim 3, characterised in that the porous layer has a thickness of between 15 and 30 µm.

5. Substrates according to claim 1, characterised in that the film is separated from the porous alumina layer by an adhesive.

6. Substrates according to claim 5, characterised in that the adhesive is able to withstand relative displacement of the conductors caused by the thermal cycles undergone by the etched circuits.

7. Substrates according to claim 5, characterised in that the adhesive is selected from the group of acrylic and epoxy resins.

8. Substrates according to claim 5, characterised in that the aluminium is selected from series 1000 according to the standards of the Aluminium Association.

9. Substrates according to claim 1, characterised in that the aluminium base has a planar configuration.

10. Substrates according to claim 9, characterised in that the aluminium base is pierced by holes, the diameter and position of which are in accordance with final use.

11. Substrates according to claim 1, characterised in that the aluminium base has a non-planar configuration.

12. Substrates according to claim 11, characterised in that the aluminium base is pierced with holes, the morphology of which is in relation to final use.

13. Substrates according to claim 1, characterised in that the metal film is made from copper.

14. Substrates according to claim 1, characterised in that the metal film belongs to a group constituted by constantan and chrome-nickel alloys.

15. Process for production of the substrates according to claim 1 comprising the treatment of an aluminium base on at least on of its faces with the aid of a porous anodising bath, then with a barrier anodising bath, characterised in that the porous anodising bath is based on sulphosalicylic acid and the barrier anodising bath is base of an aqueous solution of at least one of the following salts: ammonium tartrate, ammonium borate, potassium chlorate and ammonium citrate.

16. Process according to claim 15 characterised in that the anodising bath is formed by ammonium borate.

17. Process according to claim 15 characterised in that the metal film is obtained by physical vacuum deposition followed by electrolytic recharging.
